(19) Europäisches Patentamt
European Patent Office
Office européen des brevets

(11) **EP 3 536 519 B1**

(12) **EUROPEAN PATENT SPECIFICATION**

(45) Date of publication and mention
of the grant of the patent:
**06.10.2021  Bulletin 2021/40**

(51) Int Cl.:
***B60B 3/16*** *(2006.01)*      ***F16B 41/00*** *(2006.01)*
***G08B 21/18*** *(2006.01)*      ***G07C 5/08*** *(2006.01)*

(21) Application number: **19160740.7**

(22) Date of filing: **05.03.2019**

(54) **APPARATUS AND METHOD FOR MONITORING FASTENERS**

VORRICHTUNG UND VERFAHREN ZUR ÜBERWACHUNG VON BEFESTIGUNGSELEMENTEN

DISPOSITIF ET PROCÉDÉ POUR SURVEILLER DES MOYENS DE FIXATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **05.03.2018  US 201862638537 P
22.11.2018  US 201862770782 P**

(43) Date of publication of application:
**11.09.2019  Bulletin 2019/37**

(73) Proprietor: **i-onConnect Technologies**
**Burnaby, British Columbia V5A 4X1 (CA)**

(72) Inventors:
• **BAHRAMI YEKTA, Vahid**
**Burnaby**
**British Columbia V5A 4X1 (CA)**
• **SCHMIED, Ernst**
**Burnaby**
**British Columbia V5A 4X1 (CA)**
• **DADDEY, Ernest**
**Burnaby**
**British Columbia V5A 4X1 (CA)**

(74) Representative: **Forresters IP LLP**
**Skygarden**
**Erika-Mann-Straße 11**
**80636 München (DE)**

(56) References cited:
**US-A1- 2013 049 952     US-A1- 2017 206 720**

EP 3 536 519 B1

## Description

## FIELD

The present disclosure relates to fasteners and in particular means for detecting movement in a fastener.

## BACKGROUND

Fasteners such as nuts and bolts are commonly used to fixedly, optionally removably, connect two objects together. The fasteners are typically tightened to a sufficient torque or force that the objects will not easily come apart during operation. Fasteners are used in both moving equipment and stationary structures, but may be subject to shocks, external forces, vibration and temperature fluctuations.

These forces can act to loosen the fasteners undesirably, such that the connected objects could come apart, leading to disastrous consequences, unless they are manually inspected. Operators can visually inspect or measure the torque of the fasteners in situ but this requires constant vigilance and operator training.

Without loss of generality, an example of such a problem is loose wheel nuts on vehicles, such as trucks. The vehicle wheel nuts become loose due to improper wheel installation, road shocks, temperature variations, dirty nut threads and faulty nut threads. If they are not inspected and tightened again, the wheel itself can come off or break the wheel studs.

Another example of loose nut occurrence is in bridges. Temperature variation and shaking causes the bridge nuts and bolts to become loose. Here it is impractical to manually inspect the thousands of fasteners on a regular basis.

The inventors have appreciated the need for an automatic inspection apparatus that can remove the need for manual inspection and risk of human error. US2017/0206720 A1 discloses a wheel hub safety device for a vehicle having a hub and a wheel. The wheel hub safety device includes a housing and plurality of lug nut rotation detectors. US2013/0049952 A1 discloses an apparatus for detecting if a fastener moves from a first position to a different second position.

## SUMMARY

There are provided methods, detection devices and a wheel nut assembly relating to detecting whether the distance between two parts changes or whether a fastener become loose.

## BRIEF DESCRIPTION OF THE DRAWINGS

Fig 1 is a diagram of modules of the detection device and monitoring device.

Fig 2 is an illustration of devices installed on a truck wheel.
Fig 3A is a perspective view of a detection device.
Fig 3B is a perspective view of a detection device according to a different embodiment.
Fig 4A is a top view of two devices in a tip to tip configuration.
Fig 4B is a top view of two devices in a tip to back configuration.
Fig 5 is a side view of a device.
Fig 6 is a schematic of a signal amplifier with automatic gain control.

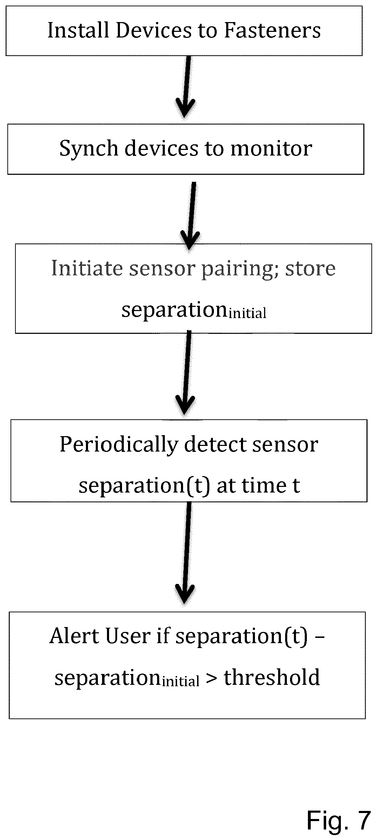

Fig 7 is a flowchart for setting up and monitoring fasteners.
Fig 8 is a diagram of components of a circuit in an active device.
Fig 9 is perspective view of detection devices mounted on fasteners.
Fig 10 is a perspective view of an active device.
Fig 11 is a perspective view of a passive device.

## DETAILED DESCRIPTION

The present disclosure provides a device, assembly and method of same to automatically detect relative movement of a fastener after it has been installed. In particular, at least some embodiments detect relative movement of a first fastener with respect to a second fastener. Devices work together and detect relative movement therebetween. Each device operates in conjunction with a second device, also called the paired device, remote device, or counterpart device. Similarly, components of the second device may be called the paired components, remote components, or counterpart components.

The System may be viewed as two distinct parts, plural detection devices that collect data and a remote monitor which processes this information and alerts a user if there is a problem. The detection devices are located on the fastener and the remote monitor may be a portable device, a gateway, or smartphone. There could be hundreds of detection devices on a vehicle or thousands on a structure reporting back to the remote monitor.

Fasteners may be nut and bolts, nails, drywall / masonry anchors, or screws. Fasteners such as nut/bolts may comprise a first part and a second part which connects to the first part in order to connect objects therebetween to be fastened. Fasteners usually rotate in one direction to tighten and in another direction to loosen. However, nails are an example of fasteners with only one part and they move axially to connect two or more objects.

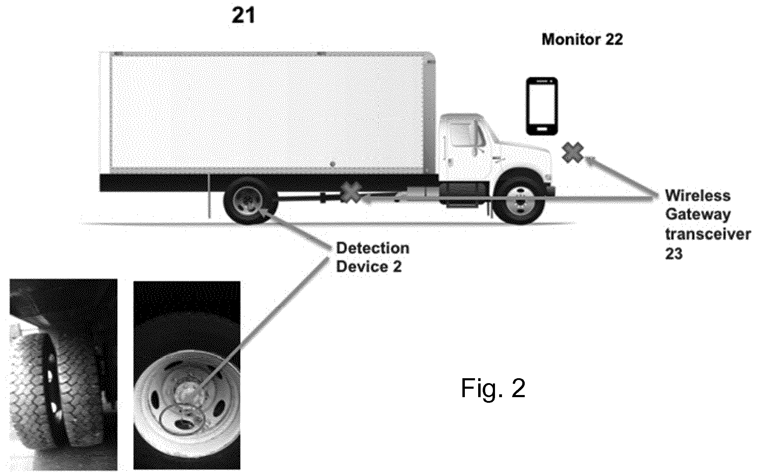

Without limiting the system or uses thereof, and by way of example, at least some embodiments may be demonstrated in use on a truck wheel, as shown in Figure 2. As shown, each truck wheel is bolted to the wheel hub by several bolts and their nuts. Each nut is capped with a detection device, which senses a spatial movement, relative to another device, due to loosening of the wheel nuts on the bolts. The monitor picks up a signal from the device to alert the driver if the movement is more than a threshold amount.

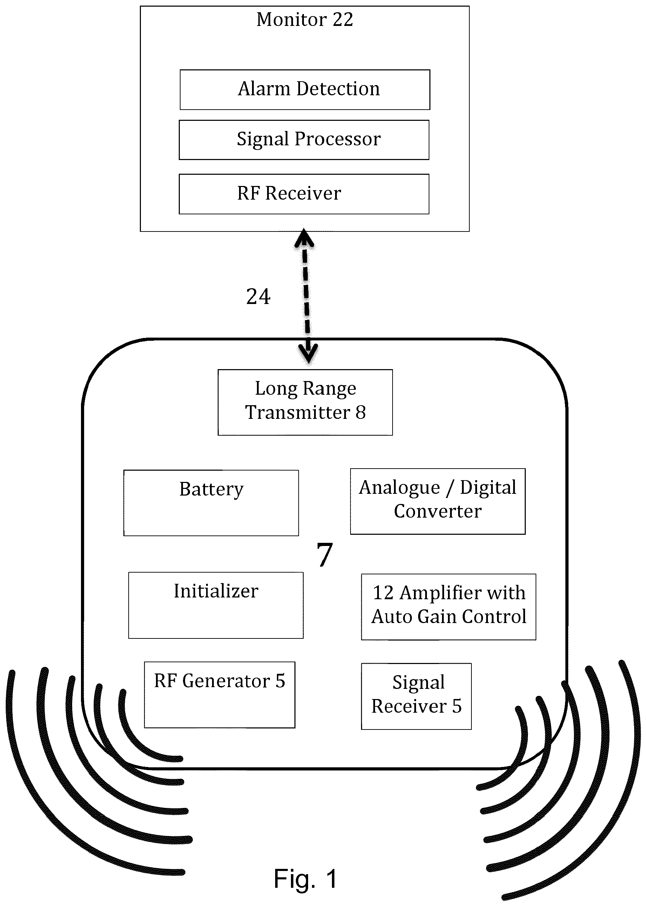

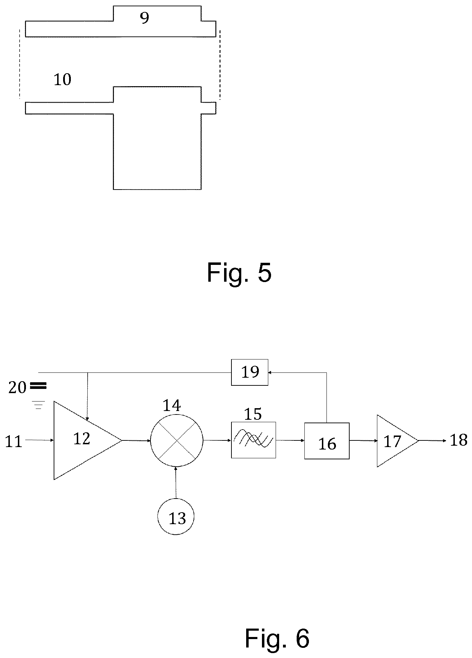

The system is further illustrated by Figs 1-6, in which the following numbered labels are used.

(1) Fastener

(2) Detection device

(3) Extension portion

(4) Short-range RF signal range

(5) Short-range RF transmitter and receiver (Tx-Rx)

(6) Body

(7) Electronics and microcontroller unit

(8) Long-range communication unit

(9) Protective cover

(10) Electronics layer

(11) Short-range RF signal input

(12) RF Amplifier

(13) Local oscillator

(14) Mixer

(15) Band-pass filter

(16) Peak detector - Received signal strength measuring tool

(17) comparator - demodulation section

(18) Signal output

(19) Gain control

(20) Capacitor

(21) Vehicle

(22) Monitor

(23) Wireless Gateway transceiver

(24) Long-range wireless signal

During installation, the hub bolts pass through holes of the wheel, the nut's internal threads rotate on the threads of the bolt, until sufficient torque is applied to clamp to all parts in place. In effect, there is a residual tension in the nut/ bolt to cause a strain on the two mating threads, such that un-fastening cannot occur unless the strain and friction are overcome.

The detection device comprises a body portion arranged to be mounted over the fastener head (e.g. nut or bolt head) and an extending portion comprising a sensor at its distal end to detect a second detection device. The extending portion extends radially outward, i.e. in the plane perpendicular to the axis of rotation of the fasteners, such that rotation of the fastener maximizes movement of the sensor with respect to the second device.

Preferably the device's extension portion comprises a flat pointing portion in order to provide a visual check of the fastener's position to users and to allow easy orientation of the device when first installed. The extensions of all the devices may be arranged to point in a pattern (such as a straight line or circle of a wheel) when first installed. The pattern provides a visual check for the operator to identify the nut which became loose when an alarm is triggered. The sensor is preferably located at the pointed portion in order to minimize the distance to the adjacent device, to which that portion is pointing.

The sensor may comprise a RF receiver and transmitter, provided together or apart. The transmitter of a first device sends a RF signal to a receiver of a second device which senses the separation of devices in terms of RF power. This raw sensor signal may be processed, amplified and measured by other circuitry. Circuitry within the device powers the transmitter to provide a short-range RF signal, within the expected range of the adjacent device.

In an alternative embodiment, the sensor is a Hall Effect sensor. A Digital Hall sensor behaves like a digital switch, having three pins, two for power and ground respectively and one output pin to indicate whether it detects a magnet or not. The advantage of using this type of hall sensor is it's simple and requires no additional hardware for detection.

Digital Hall sensors have an open-drain output that pulls Low if B (magnetic field strength) exceeds the threshold BOP (the Operate Point). The output then stays Low until B decreases below the threshold BRP (the Release Point), and then the output becomes High-Impedance. An external pull-up resistor is normally used. BOP and BRP are always separated with hysteresis (Bhys), which prevents noise-induced toggling at a threshold.

Based on the distance D between two fasteners to be detected, the magnet and Hall effect sensor pairing are chosen with a sensitivity that would be triggered if either fastener loosens by more than X°, where X is preferably 10°, more preferably 5°. Similarly, the Hall Effect sensor and Magnet are initially located as close as possible by making the extending portions each extend substantially 1/2 D from the center of the recess of the device (i.e. halfway between the fasteners.

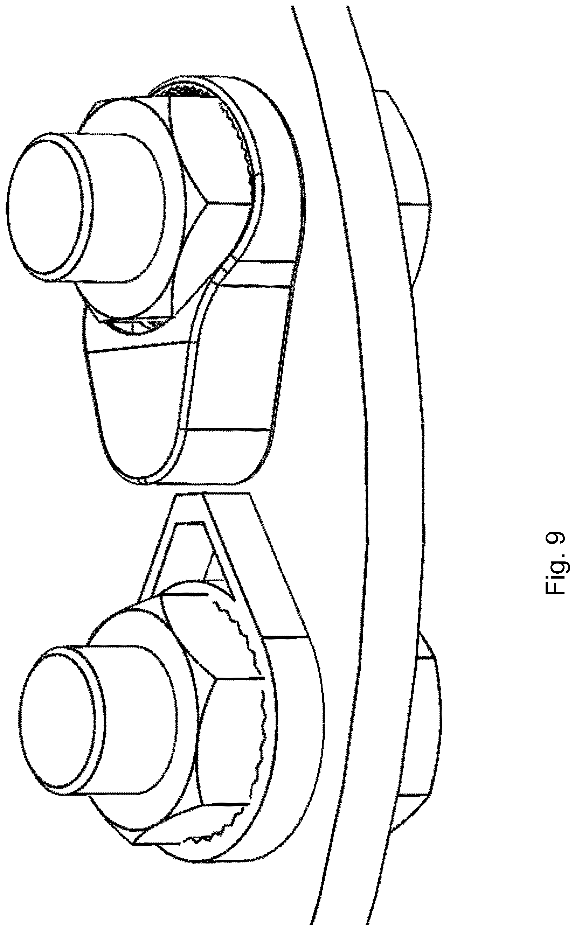

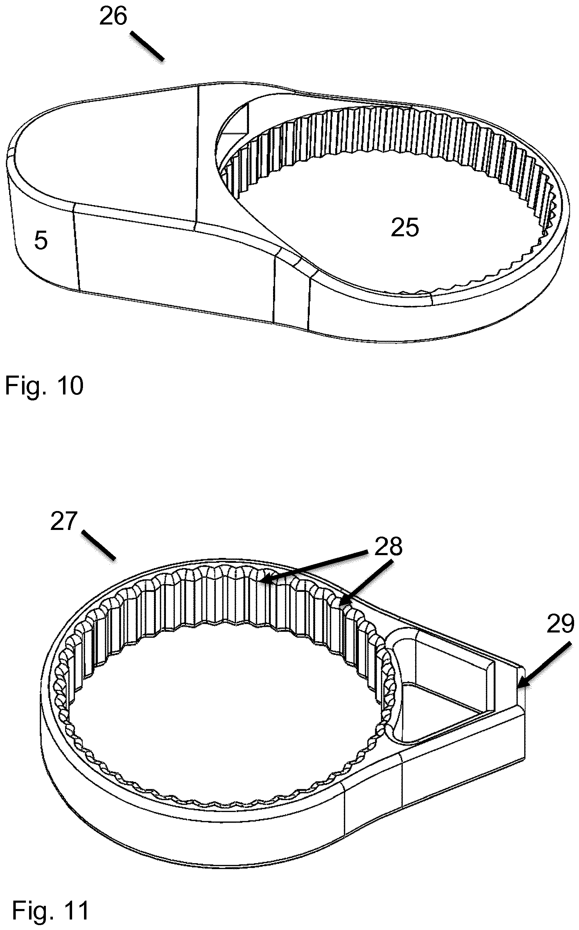

A recess 25 of the body portion may have a shape that corresponds sufficiently with the end or head of the fastener to ensure that the device and fastener stay coupled together despite vibration and other environmental forces. For example, the recess may be hexagonal to match the hexagonal head of a nut or bolt head. The device also hinders dirt from going inside the nut threads. Alternatively, the body is generally annular, ring-shaped or toroidal (i.e. the recess has a generally circular profile) and sized to tightly fit onto the fastener head, such that the device can be press fit onto the fastener, set at any angle that allows the paired sensors (or magnet and sensor) to be closest together. The inside of the recess may comprise a series of mating ridges or teeth that engage the edges of the fastener head, such that the device may be rotated into optimal orientation in small steps. There are generally many more teeth than fastener corners. Figures 9, 10, 11 show a recess 25 with 60 edges to mate with a fastener head having 6 corners. In preferred embodiments there are at least X teeth to provide a setup resolution of $\pm$ 5°.

The devices are placed on the fastener heads, selecting tooth-corner engagements, where mutual pointed portions are most closely spaced. The annular body could also be fitted with a set screw to secure it more tightly. Another option is to have part of that circle be made from a tough rubber to allow for placement on different size nuts and add support for when the groves get filed down due to wear and tear.

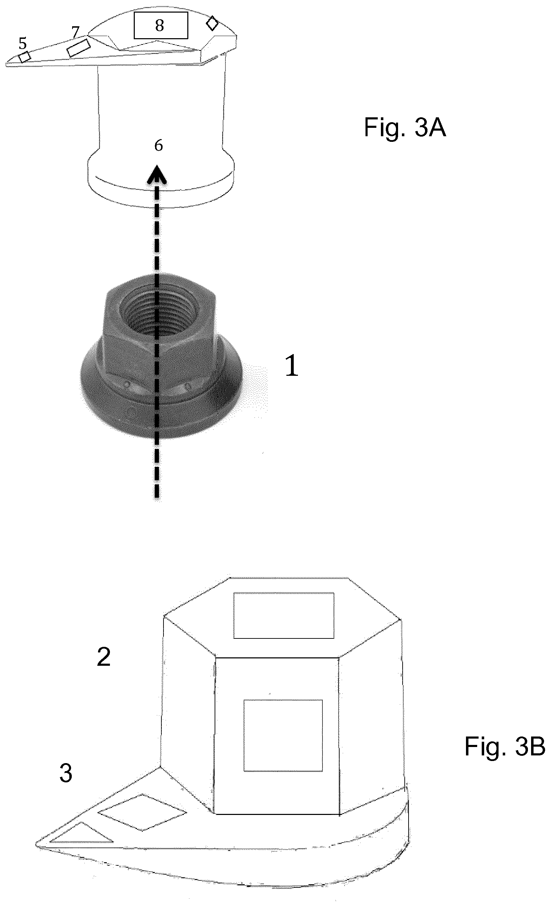

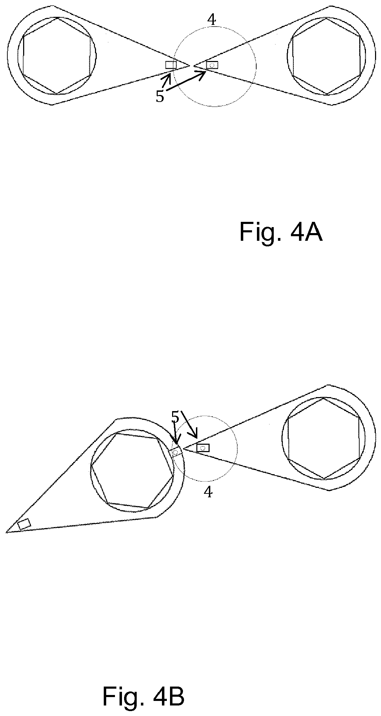

In one embodiment, each detection device has two electronic communicators. The first is a short-range RF communication unit 5 designed to send a signal and detect a signal of a second (remote) detection device's short-range RF communicator. Units 5 may be placed on the extension portions, as shown in Figure 3A, 3B, 4A, and 4B. The second communicator is a long-range communication unit 8 that transmits the measured data to the remote monitor 22. The second unit also receives a command of the monitoring system to initiate measurement. The communication with the monitoring system is coded to address each detection device and avoid interference. The communication unit 8 between the device and the monitor can be in the form of RF, Bluetooth or Wi-Fi signal. At least one communication unit 8 in a pair of matched devices sends and receives a signal from the monitoring system.

RF Transceiver

At least one detection device per wheel comprises an RF Transceiver. The advantage of using a transceiver compared to a simple transmitter is it allows a variety of smart features to the system, such as a packet acknowledgment so the detection device knows the monitor has received the wheel data. The monitor can also calculate a schedule based on the number of sensors it has to control and allocate a timeslot for each device to report data without interfering with its neighbors. This allows a mesh network, having one assigned master device per wheel, device which can communicate with its neighboring devices and only send one packet to the monitor indicating their respective status.

In one embodiment, each detection device has circuitry, such as an integrated circuit, to send and receive a sensor signal, amplify the received signal and communicate with the remote monitoring device. The circuit detects separation between two devices by measuring the received RF power, directly or indirectly.

In another embodiment, there is a first (passive) device 27 and a second (active) device 26, as shown in Figures 9, 10, 11. The first device may simply be a body comprising a recess 25 for mounting to the fastener and a magnet 29 at a location extending away from the center of the recess. The second device will then comprise the more expensive components, such as the circuitry and magnetic sensor 5.

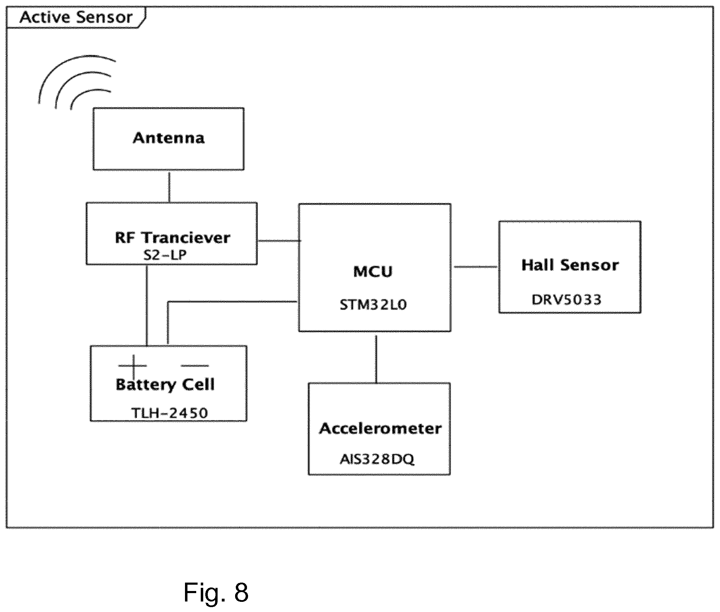

The Active Sensor 26 preferably comprises an MCU, hall effect sensor 5, RF transceiver, temperature sensor, accelerometer, antenna and battery, as illustrated in Figure 8. These may be distinct components or embedded in the MCU.

The MCU (microprocessor unit) has firmware for running instructions. It receives input from the sensor, the accelerometer and the transceiver. It also manages the battery power system.

The accelerometer provides a measure of rotational speed via the centripetal acceleration $A_c$ felt at a radius $r_{nut}$ of the nut from the wheel center. This is expressed by the equation

$$V_{tangential} = \frac{A_c}{r_{nut}}$$

The accelerometer may be at least a 2-axis linear accelerometer with a 16-bit output. Acceleration is detected in two orthogonal axes of the radial-theta plane. This resolution enables the system to determine the speed of the wheel with sufficient precision

The circuit may comprise an Automatic Gain Control (AGC) circuitry which provides a variable amount of gain so that the amplified signal is constant. Conversely a fixed amplification would either overwhelm the circuit with excess heat/signal or be insufficient to pick up a weak signal.

Moreover, the AGC circuitry enables the circuit to measure the gain in the feedback and detect a change in this gain, rather than detecting a change in the raw received signal itself. Similarly, the measure of separation may be the voltage applied by the AGC to set the amplifier gain. In testing, the circuit has been able to detect rotational movements as little as 5 degrees. The threshold to trip the alarm may correspond to a rotation of greater than 10 degrees, 45 degrees or 90 degrees.

As shown in Figures 4A and 4B the short-range signal range 4 generated by transmitter 5 is designed such that it is only picked up by the nearest neighbour device, not by other detection devices. The transmitter's power may be grossly set based on the expected separation between fasteners and fine-tuned by a feedback loop in the circuit.

In one embodiment, the short-range RF unit 5 comprises a two-channel transceiver circuit and a microcontroller circuit. The two-channel transceiver transmits a beacon to a second device on one channel and receives the second device's RF beacon on the other channel. The microcontroller arranges the communications with the monitoring system to start measurements and data transmission, it also determines the short-range transceiver's channels mode (transmitter or receiver). The transmitter and receiver in a single device may be operated out of phase such that a device does not receive its own signal. The received short-range RF signal strength is the parameter that determines the relative distance or angle of two fasteners.

At the start of separation measurement, each device transmits RF pulses of a predetermined period and power, as part of hand-shaking with its counterpart. One device transmits for a period and receives its counterpart's signal when not transmitting. An initialization algorithm on the IC, counts the number of signal pulses from the counterpart and then add delays to its transmission until there are an equal number of alternating transmissions and receptions.

The short-range RF units may use ASK (Amplitude-Shift Keying) modulation. The short-range RF transmitter may have an oscillator and a transistor circuit. The data from the microcontroller is modulated by the transmitter circuit and emitted. The short-range RF receiver circuit has an RF ASK receiver integrated circuit (IC). This IC receives the RF signal, amplifies the signal, detects the signal strength (peak) and demodulates the signal into separation data. There is feedback to control the gain of the receiver IC's amplifier to keep the signal level constant for the demodulator circuit. The feedback uses received signal strength to adjust the input amplifier's gain. The received signal strength depends on the angle and distance between the short-range transmitter and counterpart receiver, which signal strength is converted and output by the microprocessor as the separation signal. An analogue to digital converter may be used to provide a less noisy signal, which is then sent to the monitor.

After installation of the devices, each device measures the initial RF power received from its counterpart, which value may be stored on the device or monitor, called Separation-initial. Provided that the fasteners do not separate or loosen and provided that the transmitter transmits an RF signal of constant power, the received RF power should remain constant.

The monitor receives the measured separation data and alarms a user if there is change in the separation by more than a threshold amount. The alarm can be visual or sounded. The skilled person will appreciate either of the device or the monitor may store the initial spatial data, perform signal conditioning, determine a separation difference from that initial value, determine when the separation difference has exceeded a threshold, and create an alarm signal. Preferably many of these functions are performed by the monitor, with its superior processing power.

To extend the life of the battery, the electronics may be designed to only periodically measure separation and/or communicate with the monitor. For example, the circuits of paired devices may be synchronized to measure at a specific time for a period, once per day. Alternatively, the devices may be woken up to measure and communicate when motion of the vehicle is detected by the accelerometer. Alternatively, the monitor may send a wake-up signal to the devices when requested by the operator.

To preserve battery life in transport, the devices may be designed to turn on when first installed, using a switch, Hall Effect sensor to detect the magnet, or a conductive path made by the metal fastener coupled to conductive points within the recess of the body. This also prevents the devices from attempting to pair with each other in shipping or in the installers pockets.

The system and devices may also be used for detecting a locked brake of a wheel. This may be brought about by a defect or overheating of either of the disk or pad that causes them to bind, slowing down the rotation of that wheel relative to the other wheels and to the vehicle.

A device comprising the accelerometer is placed on each wheel at a known radius, such as on a wheel nut. During driving, the wheel speed of each wheel is measured by the device and sent to the gateway. If the wheel speed of a given wheel falls below the vehicle speed by a threshold amount (e.g. fixed or proportional amount) an alarm is triggered, indicating that that wheel is in a locked condition.

Compared to traction control systems that monitor wheel speed at high rates in order to control drive torque in real time, the present system monitors wheels infrequently and does not control transmission parameters.

The user places at least one active sensor per wheel. The sensor regularly sends the accelerometer readings to the monitor through the RF transceiver. The monitor processes raw data to determine the rotational speed of the wheel. Based on the monitor's own accelerometer, it can compare the rotational speed of each wheel to the speed of the truck. If the wheel speed is below a threshold percentage of the actual truck speed it issues an alarm to the driver.

In an alternatively use, the detection devices are coupled to fasteners in a wall to detect cracking and movement between the pairs of devices. For example, devices may be placed on either side of an observed crack or structural seam, the initial separation measured and stored, and the real-time separation monitored to determine whether a structure is coming apart.

## Claims

1. A method of detecting loosening of fasteners (1) in a system having a first device (2) fixed to a first fastener and a second device (2) fixed to a second fastener, the first and second device comprising a body portion (6) arranged for mounting to a fastener and a portion (3) extending from the body (6), the method comprising:

monitoring a sensor (5) integrated with the first device and located on the extended portion (3), which sensor (5) detects the second device to measure a separation of the extended portion (3) of the first device (2) from the second device (2); sending a wireless signal including the measured separation data from the first device (2) to a monitor (22); and providing an alert if there is a change in a signal level of the sensor (5) from an initial level.

2. The method of claim 1, further comprising providing an RF signal from the second device (2), which signal is sensed by an RF receiver comprised in the sensor (5) of the first device.

3. The method of claim 1 or 2, further comprising determining if there is a change in signal level of the sensor (5) by monitoring a gain level in an automatic gain control of an amplifier (12) of the signal from the sensor (5).

4. The method of claim 1, 2 or 3, wherein monitoring the sensor (5) is performed when an accelerometer comprised in the first device (2) indicates rotation of the first fastener (1).

5. The method of any preceding claim, wherein monitoring the sensor is performed at predetermined times and not performed between those times.

6. The method of any preceding claim, wherein the alert is provided if the change in sensor level is greater than a threshold.

7. The method of any preceding claim, wherein the sensor is a magnetic sensor selected from one of: a Hall Effect Sensor, an Inductive sensor, and a MEMS magnetic sensor.

8. The method of claim 7, wherein the second device comprises a magnet or ferritic material and wherein the separation is measured as a change in magnetic field if the magnet or ferritic material moves away from the magnetic sensor.

9. A detection device (2) for detecting loosening of a fastener (1) comprising:

a body portion (6) arranged for mounting to a fastener (1); a portion (3) extending from the body (6); a sensor (5) located on the extended portion (3) and arranged to detect an adjacent detection device (2) of another fastener (1) and to measure a separation of the extended portion from the adjacent detection device; circuitry arranged to measure a signal from the sensor (5) and to send a wireless signa including the sensor signal to a monitor (22).

10. The detection device (2) of claim 9, wherein the sensor (5) comprises a RF receiver.

11. The detection device (2) of claim 9 or 10, further comprising a RF transmitter (5).

12. The detection device (2) of any one of claims 9 to 11, wherein the body (6) comprises a recess for receiving a head of the fastener (1).

13. The detection device (2) of any one of claims 9 to 12, wherein the sensor (5) is a magnetic sensor, preferably a Hall Effector Sensor.

14. A wheel nut assembly comprising:

a plurality of separation detection devices (2), each said device (2) fit to a wheel nut with a sensor (5) in an extended portion (3) extending towards an adjacent device (2), wherein each sensor (5) is arranged to detect its adjacent device (2) and to measure a distance between the sensor (5) and the adjacent device (2); and a monitor (22), remote from the devices (2), arranged to receive a signal from said devices (2), such that a loosening of any wheel nut causes a change in one of the measured distances, which change raises an alarm on the monitor (22).

## Patentansprüche

1. Verfahren zum Erkennen eines Lösens von Befestigungselementen (1) in einem System mit einer ersten, an einem ersten Befestigungselement befestigten Vorrichtung (2) und einer zweiten, an einem zweiten Befestigungselement befestigten Vorrichtung (2), wobei die erste und die zweite Vorrichtung einen der zum Befestigen an einem Befestigungselement angeordneten Körperabschnitt (6) und einen von dem Körper (6) abstehenden Abschnitt (3) umfassen, wobei das Verfahren Folgendes beinhaltet:

Überwachen eines Sensors (5), der in die erste Vorrichtung integriert ist und sich auf dem abstehenden Abschnitt (3) befindet, wobei der Sensor (5) die zweite Vorrichtung erkennt, um einen Abstand des abstehenden Abschnitts (3) der ersten Vorrichtung (2) von der zweiten Vorrichtung (2) zu messen;

Senden eines drahtlosen Signals einschließlich der gemessenen Abstandsdaten von der ersten Vorrichtung (2) an einen Monitor (22); und

Geben eines Warnsignals, wenn sich ein Signalpegel des Sensors (5) gegenüber einem Anfangspegel ändert.

2. Verfahren nach Anspruch 1, das ferner das Geben eines HF-Signals von der zweiten Vorrichtung (2) umfasst, wobei das Signal von einem HF-Empfänger erfasst wird, der in dem Sensor (5) der ersten Vorrichtung enthalten ist.

3. Verfahren nach Anspruch 1 oder 2, das ferner das Bestimmen, ob eine Änderung des Signalpegels des Sensors (5) vorliegt, durch Überwachen eines Verstärkungspegels in einer automatischen Verstärkungsregelung eines Verstärkers (12) des Signals vom Sensor (5) beinhaltet.

4. Verfahren nach Anspruch 1, 2 oder 3, wobei die Überwachung des Sensors (5) dann erfolgt, wenn ein in der ersten Vorrichtung (2) enthaltener Beschleunigungsmesser eine Rotation des ersten Befestigungselements (1) anzeigt.

5. Verfahren nach einem vorherigen Anspruch, wobei die Überwachung des Sensors zu vorbestimmten Zeiten durchgeführt und zwischen diesen Zeiten nicht durchgeführt wird.

6. Verfahren nach einem vorherigen Anspruch, wobei das Warnsignal ausgelöst wird, wenn die Änderung des Sensorpegels größer als ein Schwellenwert ist.

7. Verfahren nach einem vorherigen Anspruch, wobei der Sensor ein Magnetsensor ist, ausgewählt aus: einem Hall-Effekt-Sensor, einem induktiven Sensor und einem MEMS-Magnetsensor.

8. Verfahren nach Anspruch 7, wobei die zweite Vorrichtung einen Magneten oder ein ferritisches Material umfasst und wobei die Trennung als eine Änderung des Magnetfelds gemessen wird, wenn sich der Magnet oder das ferritische Material von dem Magnetsensor wegbewegt.

9. Detektionsvorrichtung (2) zum Erkennen eines Lösens eines Befestigungselements (1), die Folgendes umfasst:

einen Körperabschnitt (6), ausgelegt zum Montieren an einem Befestigungselement (1);

einen Abschnitt (3), der vom Körper (6) absteht;

einen Sensor (5), der sich auf dem abstehenden Abschnitt (3) befindet und zum Erkennen einer benachbarten Detektionsvorrichtung (2) eines anderen Befestigungselements (1) und zum Messen eines Abstands des abstehenden Abschnitts von der benachbarten Detektionsvorrichtung ausgelegt ist;

eine Schaltung, ausgelegt zum Messen eines Signals vom Sensor (5) und zum Senden drahtloser Signale einschließlich des Sensorsignals an einen Monitor (22).

10. Detektionsvorrichtung (2) nach Anspruch 9, wobei der Sensor (5) einen RF-Empfänger umfasst.

11. Detektionsvorrichtung (2) nach Anspruch 9 oder 10, die ferner einen RF-Sender (5) umfasst.

12. Detektionsvorrichtung (2) nach einem der Ansprüche 9 bis 11, wobei der Körper (6) eine Ausnehmung zum Aufnehmen eines Kopfs des Befestigungselements (1) aufweist.

13. Detektionsvorrichtung (2) nach einem der Ansprüche 9 bis 12, wobei der Sensor (5) ein Magnetsensor, vorzugsweise ein Hall-Effektor-Sensor, ist.

14. Radmutteranordnung, die Folgendes umfasst:

mehrere Trennungsdetektionsvorrichtungen (2), wobei jede genannte Vorrichtung (2) mit einem Sensor (5) in einem in Richtung einer benachbarten Vorrichtung (2) abstehenden Abschnitt (3) an einer Radmutter angebracht wird, wobei jeder Sensor (5) zum Erkennen ihrer benachbarten Vorrichtung (2) und zum Messen eines Abstands zwischen dem Sensor (5) und der benachbarten Vorrichtung (2) ausgelegt ist; und

einen Monitor (22) fern von den Vorrichtungen (2), ausgelegt zum Empfangen eines Signal von den Vorrichtungen (2),

so dass ein Lösen einer Radmutter eine Änderung in einem der gemessenen Abstände verursacht, wobei diese Änderung einen Alarm auf dem Monitor (22) auslöst.

## Revendications

1. Procédé de détection de desserrage d'éléments de fixation (1) dans un système comportant un premier dispositif (2) fixé à un premier élément de fixation et un second dispositif (2) fixé à un second élément de fixation, les premier et second dispositifs comprenant une partie corps (6) conçue pour être montée sur un élément de fixation et une partie (3) s'étendant depuis le corps (6), le procédé consistant à :

surveiller un capteur (5) intégré avec le premier dispositif et situé sur la partie étendue (3), ledit capteur (5) détectant le second dispositif pour mesurer une séparation de la partie étendue (3) du premier dispositif (2) à partir du second dispositif (2) ;

envoyer à un moniteur (22) un signal sans fil influant les données de séparation mesurées à partir du premier dispositif (2) ; et

fournir une alerte s'il y a une variation d'un niveau de signal du capteur (5) à partir d'un niveau initial.

2. Procédé selon la revendication 1, consistant en outre à fournir un signal RF à partir du second dispositif (2), ledit signal étant détecté par un récepteur RF compris dans le capteur (5) du premier dispositif.

3. Procédé selon la revendication 1 ou 2, consistant en outre à déterminer s'il y a une variation d'un niveau de signal du capteur (5) en surveillant un niveau de gain dans une commande automatique de gain d'un amplificateur (12) du signal en provenance du capteur (5).

4. Procédé selon la revendication 1, 2 ou 3, dans lequel la surveillance du capteur (5) est réalisée quand un accéléromètre compris dans le premier dispositif (2) indique une rotation du premier élément de fixation (1).

5. Procédé selon l'une quelconque des revendications précédentes, dans lequel la surveillance du capteur est réalisée à des temps prédéterminés et n'est pas réalisée entre ces temps.

6. Procédé selon l'une quelconque des revendications précédentes, dans lequel l'alerte est fournie si la variation d'un niveau de capteur est supérieure à un seuil.

7. Procédé selon l'une quelconque des revendications précédentes, dans lequel le capteur est un capteur magnétique choisi parmi : un capteur à effet Hall, un capteur inductif et un capteur magnétique MEMS.

8. Procédé selon la revendication 7, dans lequel le second dispositif comprend un matériau magnétique ou ferritique et dans lequel la séparation est mesurée comme une variation d'un champ magnétique si le matériau magnétique ou ferritique s'éloigne du capteur magnétique.

9. Dispositif de détection (2) pour détecter un desserrage d'un élément de fixation (1), comprenant :

une partie corps (6) conçue pour être montée sur un élément de fixation (1) ;

une partie (3) s'étendant depuis le corps (6) ;

un capteur (5) situé sur la partie étendue (3) et conçu pour détecter un dispositif de détection adjacent (2) d'un autre élément de fixation (1) et pour mesurer une séparation de la partie étendue à partir du dispositif de détection adjacent ;

une circuiterie conçue pour mesurer un signal en provenance du capteur (5) et pour envoyer à un moniteur (22) un signal sans fil incluant le signal de capteur.

10. Dispositif de détection (2) selon la revendication 9, dans lequel le capteur (5) comprend un récepteur RF.

11. Dispositif de détection (2) selon la revendication 9 ou 10, comprenant en outre un émetteur RF (5).

12. Dispositif de détection (2) selon l'une quelconque des revendications 9 à 11, dans lequel le corps (6) comprend un évidement pour recevoir une tête de l'élément de fixation (1).

13. Dispositif de détection (2) selon l'une quelconque des revendications 9 à 12, dans lequel le capteur (5) est un capteur magnétique, de préférence un capteur à effet Hall.

14. Ensemble écrou de roue, comprenant :

une pluralité de dispositifs de détection de séparation (2), chacun desdits dispositifs (2) s'ajustant sur un écrou de roue avec un capteur (5) dans une partie étendue (3) s'étendant vers un dispositif adjacent (2), chaque capteur (5) étant conçu pour détecter un dispositif adjacent (2) et pour mesurer une distance entre le capteur (5) et le dispositif adjacent (2) ; et

un moniteur (22), distant des dispositifs (2), agencé pour recevoir un signal en provenance desdits dispositifs (2),

de sorte qu'un desserrage d'un quelconque écrou de roue provoque une variation d'une des distances mesurées, ladite variation déclenchant une alarme sur le moniteur (22).

Monitor 22

Alarm Detection

Signal Processor

RF Receiver

24

Long Range
Transmitter 8

Battery

Analogue / Digital
Converter

7

Initializer

12 Amplifier with
Auto Gain Control

RF Generator 5

Signal
Receiver 5

Fig. 1

21

Monitor 22

Wireless Gateway transceiver 23

Detection Device 2

Fig. 2

Fig. 3A

Fig. 3B

Fig. 4A

Fig. 4B

## Fig. 5

## Fig. 6

Install Devices to Fasteners

Synch devices to monitor

Initiate sensor pairing; store

separation$_{initial}$

Periodically detect sensor

separation(t) at time t

Alert User if separation(t) –

separation$_{initial}$ > threshold

Fig. 7

Fig. 8

Fig. 9

EP 3 536 519 B1

Fig. 10

Fig. 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20170206720 A1

- US 20130049952 A1